# EUROPEAN PATENT SPECIFICATION

(11) **EP 0 772 241 B1**
(45) Date of publication and mention of the grant of the patent: **09.06.2004**
(21) Application number: 95830453.7
(22) Date of filing: 30.10.1995
(51) Int. Cl.: H01L 29/06, H01L 29/10, H01L 29/78, H01L 29/739

(54) **High density MOS technology power device**
Leistungsbauteil hoher Dichte in MOS-Technologie
Dispositif de puissance à haute densité en technologie MOS

(43) Date of publication of application: 07.05.1997
(73) Proprietor: STMicroelectronics S.r.l., 20041 Agrate Brianza (Milano) (IT); Consorzio per la Ricerca sulla Microelettronica nel Mezzogiorno, 95121 Catania (IT)
(72) Inventor: Magri', Angelo, I-95032 Belpasso (Catania) (IT); Frisina, Ferruccio, I-95030 Sant'Agata li Battiati (Catania) (IT); Ferla, Giuseppe, I-95126 Catania (IT)
(74) Representative: Mittler, Enrico

(56) References cited:
- EP-A- 0 252 236
- EP-A- 0 405 138
- EP-A- 0 543 313
- WO-A-94/11904
- US-A- 4 345 265

## Description

The present invention relates to a high density MOS technology power device.

MOS technology power devices are composed of a plurality of elementary functional units integrated in a same semiconductor chip. Each elementary functional unit forms an elementary vertical MOSFET, and aLL the elementary functional units are connected in parallel; in this way, each elementary vertical MOSFET contributes for a respective fraction to the overaLL current of the power device.

A MOS technology power device chip comprises a lightly doped semiconductor layer of a first conductivity type forming a common drain layer for all the elementary vertical MOSFETs; the lightly doped layer is superimposed over a heavily doped semiconductor substrate. Each elementary functional unit comprises a body region of a second conductivity type formed in the drain layer. In the case of "cellular" power devices (the most common case), the body region of the elementary functional units has a polygonal Layout, for example square or hexagonal; for this reason, the elementary functional units are also called "elementary ceLLs". However, MOS technology power devices are also known wherein the body region of the elementary functional units is an elongated stripe.

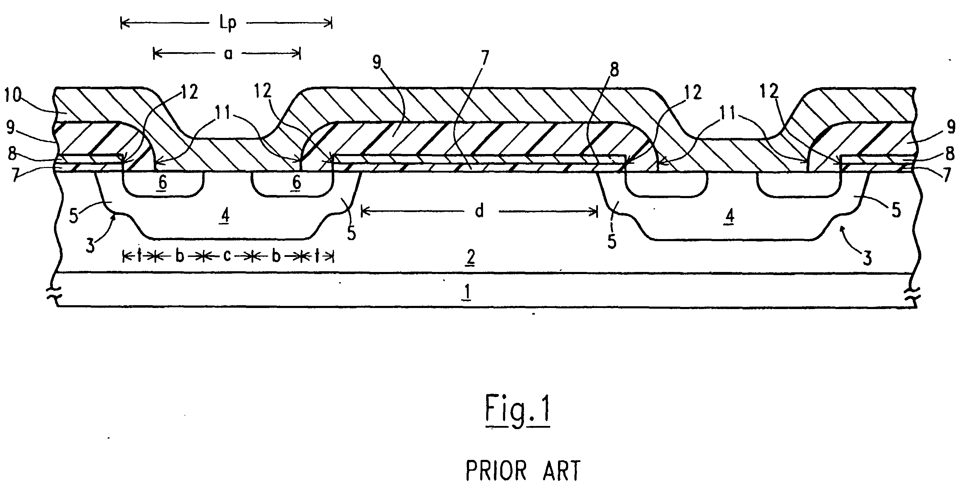

In both cases, the vertical structure of the elementary functional units (i.e. the cross-section of the cell or of the stripes) is as shown in Fig. 1, wherein the heavily doped semiconductor substrate is indicated by 1 and the common drain layer is indicated by 2. The body region 3 of the elementary functional unit comprises a central heavily doped portion 4, caLLed "deep body region", and a lateral portion 5, having a lower dopant concentration, forming the channel region of the elementary vertical MOSFET; the doping level of the lateral portion 5 of the body region determines the threshold voltage of the power device. Inside the body region 3, two source regions 6 of the same conductivity type as the common drain layer 2 are formed. A thin oxide layer 7 (gate oxide) and a poLysiLicon layer 8 (the gate electrode of the power device) cover the surface of the portions of the drain layer 1 between the body regions 3, and extend over the lateral portions 5 of the body region. The poLysiLicon layer 8 is covered by a dielectric layer 9 in which contact windows 11 are opened over each body region to allow a superimposed metal layer 10 (the source electrode of the power device) to come into contact with the source regions 6 and with the deep body region 4. The short-circuit between the source regions and the body region is essential to prevent a parasitic bipolar junction transistor having emitter, base and collector formed by the source regions, the body region and the drain Layer 1 from triggering on; the heavily doped deep body region 4 increases the ruggedness of the power device because it reduces the base resistance of such a parasitic transistor.

For the manufacturing of the structure described above, the following steps are required:
- formation of the drain layer 2 over the substrate 1 (generally by means of an epitaxial growth;
- thermal growth of the thin oxide layer 7 over the whole active area of the drain layer 2 (the active area being the portion of the drain Layer wherein the elementary functional units of the MOS power device wiLL be formed), and deposition of the poLysiLicon layer 8;
- selective introduction of high dose of dopants to form the heavily doped deep body regions 4;
- selective etching of the poLysiLicon and oxide layers to open windows 12 where the elementary functional units will be formed;
- selective introduction of a low dose of dopants into the drain Layer through said windows to form the lightly doped portions of the body regions;
- formation of the source regions 6;
- deposition of the dielectric layer 9 and selective etching thereof to open the contact windows 11;
- deposition and patterning of the metal layer 10.

This process involves the use of four photolithographic masks: a first mask is used for the formation of the deep body regions 4; a second mask is used to selectively etch the poLysiLicon and oxide layers; a third mask is used to form the source regions 6 (the mask for the introduction of the dopants forming the source regions is provided partially by the poLysiLicon and oxide layers, and partially by photoresist isles over the middle portion of the deep body regions); a fourth mask is used to open the contact windows in the dielectric Layer.

Referring again to Fig. 1, the dimension Lp of each window 12 in the polysilicon and gate oxide layers is given by:$\text{Lp = a + 2t}$ where a is the dimension of the contact window 11 in the dielectric layer and t is distance between the edge of the poLysiLicon Layer and the edge of the dielectric layer. The dimension a of the contact window is in turn:$\text{a = c + 2b}$ where b is the distance between the edge of the contact window and the inner edge of the source region (i.e. the length of the portion of source region available to be contacted by the metal layer), and c is the dimension of the middle portion of the body region wherein the source regions are absent (i.e. the distance between the inner edges of the source regions, corresponding to the Length of the portion of body region available to be contacted by the metal Layer). The dimension Lp is therefore given by:$\text{Lp = c + 2b + 2t}$ and the elementary functional units have a dimension determined by "three feature size", because their dimension depends on the three parameters c, b and t.

In MOS technology power devices, the electrical parameters to be optimized are the output resistance in the on condition (Ron), the gate-to-drain capacitance (feedback capacitance) and the gate-to-source capacitance (input capacitance).

The output resistance Ron is the sum of several components, each of which is associated with a particular physical region of the device. More specifically, it is:$\text{Ron = Rc + Racc + Rjfet + Repy}$ where Rc (channel resistance) is the component associated with the channel region, Racc (accumulation region resistance) is the component associated with the surface region of the portion of drain layer comprised between the body regions, Rjfet is the component associated with the portion of drain layer comprised between the depletion regions of the body regions, and Repy is the component associated with the portion of the drain layer beneath the body regions.

The Rc component depends on process parameters such as the dopant concentration of the channel region (i.e. on the threshold voltage of the MOS power device) and on the channel length; the Racc component depends on the distance between two adjacent body regions, and decreases as such distance decreases; the Rjfet component depends on the resistivity of the drain layer and on the distance between the body regions, and increases as such a distance decreases; the Repy component depends on the resistivity and thickness of the drain Layer, two parameters which determine the maximum voltage that can be sustained by the MOS power device.

Further, the Ron is inversely proportional to the overall channel perimeter of the MOS power device, i.e. to the sum of the channel perimeters of the individual elementary functional units that compose the MOS power device. The Longer the channel perimeter per unit area of the MOS power device, the lower the Ron per unit area.

In order to reduce the Ron it is essential to scale down the dimensions of the elementary functional units and the distance (d in Fig. 1) between them, i.e. to increase the density of elementary functional units per unit area. The reduction of the distance d between the body regions has the further advantage of lowering the input and feedback capacitances of the MOS power device, thus improving its dynamic performance. Also, it has been verified that in high-voltage MOS technology power devices reducing the distance between the body wells increases the device's ruggedness under switching conditions.

In the Last years, the technological trend has therefore been toward the increase of the density of elementary functional units per unit area, and nowadays MOS technology power devices with a density of up to six million elementary cells per square inch can be fabricated.

The current structure of the elementary functional units poses however some Limitations to the further reduction of the dimensions thereof. These Limitations are essentially determined by the resolution and the alignment characteristics of the photolithographic apparatus. Referring again to Fig. 1, it appears that the dimension c must be sufficiently Large to guarantee that the metal layer contacts the body region, and can be scaled down to the resolution limit of the photolithographic apparatus; the dimension b must be sufficiently large to guarantee that the metal layer contacts the source region, and must also take into account the alignment errors between the mask defining the contact window 11 in the dielectric layer and the mask for the formation of the source regions; the dimension t must be sufficiently Large to guarantee that the poLysiLicon layer is electrically insulated from the metal layer, and must also take into account the alignment errors between the masks for the definition of the windows in the poLysiLicon layer and in the dielectric Layer.

In addition, the current structure of the elementary functional units does not allow to reduce the distance between the elementary functional units below specified values that depend on the voltage rating of the MOS power device (approximately 5 µm for low-voltage devices and from 10 µm to 30 µm for medium- and high-voltage devices). The reduction of such a distance below said specified values would in fact cause a rapid increase in the Rjfet component of the Ron of the MOS power device.

WO-A-9411904 discloses a device and a method for improving current carrying capability in a semiconductor device.

EP-A-543313 discloses a field effect transistor having pack gate held in contact with source electrode without variation in source contact resistance.

EP-A-252236 discloses a vertical MOS type semiconductor device.

EP-A-4345265 and EP-A-405138 disclose a MOS technology power device comprising a plurality of MOS power transistors formed in a semiconductor layer of a first conductivity type. Each MOS power transistor comprises a body region of a second conductivity type formed in the semiconductor material layer; the body region has the form of a body stripes elongated in a longitudinal direction on a surface of the semiconductor material layer. The body stripe includes a plurality of source portions doped with dopants of the first conductivity type. The plurality of source portions is intercalated in the longitudinal direction with a plurality of body portions of the body stripe wherein no dopants of the first conductivity type are provided.

In view of the state of the art described, it is an object of the present invention to provide a new MOS technology power device structure which allows to achieve higher scales of integration.

According to the present invention, such object is attained by means of a MOS technology power device as defined in claim 1.
Fig. 1 is a cross-sectional view of a MOS technology power device according to the prior art;
Fig. 2 is a top-plan view of a portion of MOS technology power device according to a first embodiment of the present invention;
Fig. 3 is a cross-sectional view along Line III-III in Fig. 2;
Fig. 4 is a cross-sectional view along line IV-IV in Fig. 2;
Fig. 5 is a top-plan view showing the Layout and the reciprocal alignment of some photolithographic masks used for the fabrication of the MOS technology power device of Fig. 2;
Fig. 6 is a top-plan view of a portion of MOS technology power device according to a second embodiment of the present invention;
Fig. 7 is a cross-sectional view along line VII-VII in Fig. 6;
Fig. 8 is a cross-sectional view along line VIII-VIII in Fig. 6;
Fig. 9 is a cross-sectional view along line IX-IX in Fig. 6;
Fig. 10 is a top-plan view showing the Layout and the reciprocal alignment of some photolithographic masks used for the fabrication of the MOS technology power device of Fig. 6;
Fig. 11 is a top-plan view of a portion of a non-claimed MOS technology power device.
Fig. 12 is a cross-sectional view along line XII-XII in Fig. 11;
Fig. 13 is a cross-sectional view along line XIII-XIII in Fig. 11;
Fig. 14 is a top-plan view showing the Layout and the reciprocal alignment of some photolithographic masks used for the fabrication of the MOS-technology power device of Fig. 11;
Fig. 15 is a top-plan view of a portion of a non-claimed MOS technology power device.
Fig. 16 is a cross-sectional view aLong Line XVI-XVI in Fig. 15;
Fig. 17 is a cross-sectional view along line XVII-XVII in Fig. 15;
Fig. 18 is a top-plan view showing the Layout and the reciprocal alignment of some photolithographic masks used for the fabrication of the MOS technology power device of Fig. 15;
Fig. 19 is a top-plan view of a portion of a non-claimed MOS technology power device.
Fig. 20 is a cross-sectional view along Line XX-XX in Fig. 19; and
Fig. 21 is a top-plan view showing the Layout and the reciprocal alignment of some masks used for the fabrication of the MOS technology power device of Fig. 19.

Fig. 1 is a cross-sectional view of a MOS technology power device chip according to the prior art. The chip comprises a heavily doped semiconductor substrate 1, over which a LightLy doped epitaxial layer 2 of a first conductivity type is formed. The MOS power device is composed of a pLuraLity of elementary functional units, formed in the epitaxial Layer 2. Two of said elementary functional units are visible in Fig. 1. Each elementary functional units comprises a body region 3 of a second conductivity type formed in the epitaxial layer 2. The body regions 3 can have a polygonal Layout (for example square or hexagonal), or can be elongated stripes (in this case, Fig. 1 is a cross-section in a direction transversal to the stripes). The body region 3 of the elementary functional unit comprises a central heavily doped portion 4, called "deep body region", and a lateral portion 5, having a lower dopant concentration, forming a channel region; the doping level of the LateraL portion 5 of the body region determines the threshold voltage of the power device. Inside the body region 3, two source regions 6 of the same conductivity type as the epitaxial Layer 2 are formed. A thin oxide layer 7 (gate oxide) and a poLysiLicon Layer 8 cover the surface of the portions of the drain Layer 2 between the body regions 3, and extend over the lateral portions 5 of the body regions 3. Windows 12 are provided in the polysilicon and gate oxide layers 8, 7 over the body regions 3. The poLysiLicon Layer 8 is covered by a dielectric layer 9 in which contact windows 11 are opened over each body region 3, to allow a superimposed metal layer 10 (the source electrode of the power device) to come into contact with the source regions 6 and the deep body regions 4.

The size of an elementary functional unit of the MOS power device substantially corresponds to the dimension Lp of the window 12 in the poLysiLicon and gate oxide Layers 8 and 7. As visible, such a dimension is:$\text{Lp = a + 2t}$ where a is the dimension of the contact window 11 in the dielectric Layer 9 and t is distance between the edge of the poLysiLicon layer and the edge of the dielectric layer. The dimension a of the contact window is, in turn:$\text{a = c + 2b}$ where b is the distance between the edge of the contact window 11 and the inner edge of the source region 6 (i.e. the Length of the portion of source region available to be contacted by the source metal layer 10), and c is the dimension of the middle portion of the body region wherein the source regions 6 are absent (i.e. the distance between the inner edges of the source regions 6, corresponding to the length of the portion of the body region 3 available to be contacted by the source metal layer 10). The dimension Lp is therefore:$\text{Lp = c + 2b + 2t.}$

The dimension of the elementary functional units is therefore determined by the three feature sizes c, b and t.

In the following description, the same numerals used in Fig. 1 will be adopted to indicate similar parts.

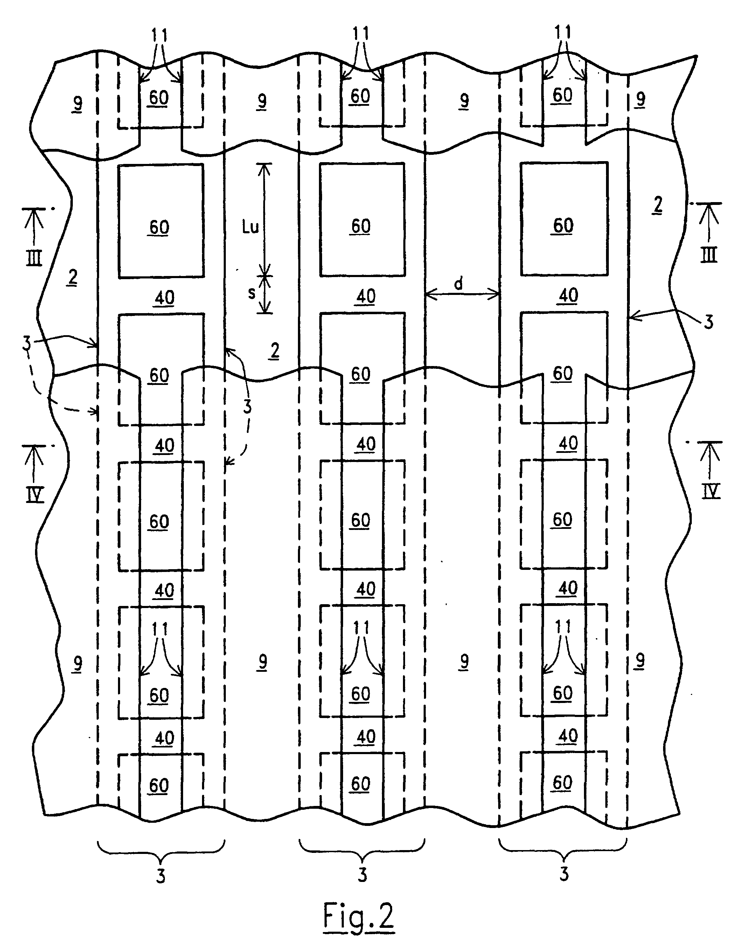

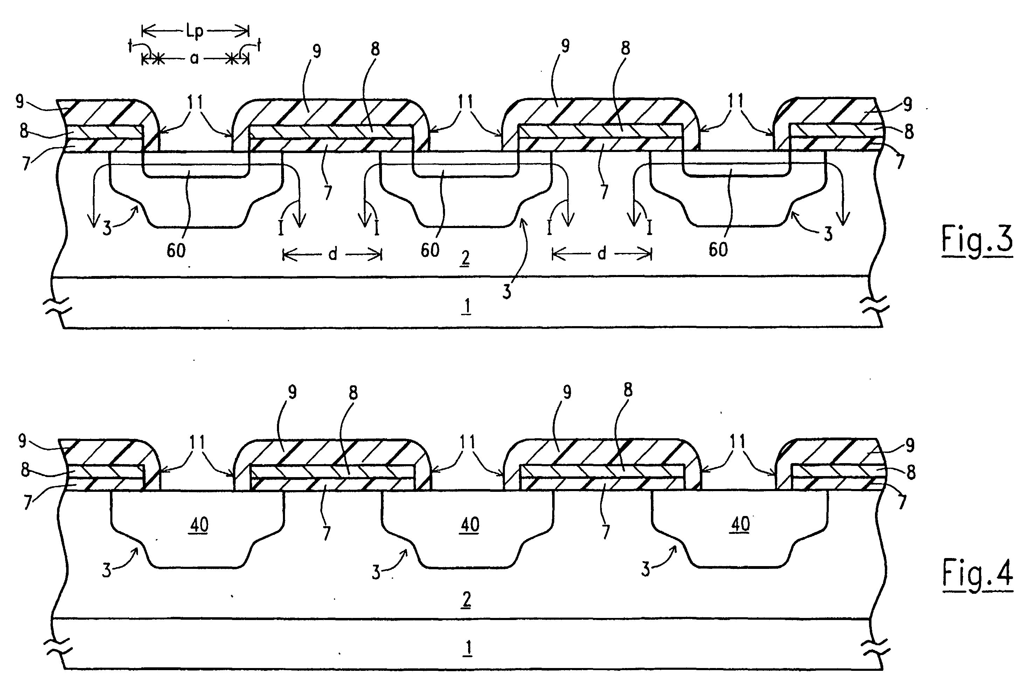

Fig. 2 is a top-plan view of a portion of a MOS technology power device according to a first embodiment of the present invention. As visible in conjunction with Figs. 3 and 4, the MOS power device comprises an epitaxial layer 2 forming a common drain layer; the epitaxial layer 2 is of the N conductivity type for an N channel device and of the P conductivity type for a P channel device. The epitaxial layer 2 is formed over a heavily doped substrate 1; in the case of a power MOSFET the substrate 1 is of the same conductivity type as the epitaxial layer 2, while in the case of an Insulated Gate Bipolar Transistor (IGBT) the substrate 1 and the epitaxial layer 2 are of opposite conductivity types.

The MOS power device comprises a pLuraLity of elementary functional units formed in the drain layer 2. Each elementary functional unit comprises a body region 3 of the opposite conductivity type of the drain layer 2; the body regions 3 have the form of substantially parallel elongated stripes spaced apart of a distance d.

Inside each body stripe 3, a pLuraLity of heavily doped regions 60 of the opposite conductivity type of the stripe 3 is provided; the regions 60 extend in the longitudinal direction of the body stripes 3, and are intercalated with transversal portions 40 of the body stripe 3. The regions 60 form source regions of the MOS power device.

The surface of the drain layer 2 is covered by a silicon dioxide layer 7 (gate oxide) and a polysilicon layer 8 forming the gate electrode of the MOS power device; the gate oxide layer 7 and the polysilicon layer 8 extend over the stripes 3 to the edges of the regions 60. A dielectric layer 9 covers the poLysiLicon Layer 8. ELongated openings 11 (contact windows) are provided in the dielectric layer 9 over the central portion of the stripes 3 to allow a metal layer (not shown) forming the source electrode of the MOS power device to contact both the source regions 60 and the transversal portions 40 of the body stripes 3.

As visible in Fig. 3, the transversal dimension Lp of the window in the poLysiLicon and gate oxide layers 8 and 7 is given, as in the prior art structures, by:$\text{Lp = a + 2t}$ where a is the transversal dimension of the contact window 11 and t is the distance between the edge of the poLysiLicon Layer and the edge of the dielectric layer 9.

However, in the structure of the invention, thanks to the fact that the source regions 60 are intercalated in the longitudinal direction of the body stripes 3 with the transversal portions 40 of the body stripes 3 wherein the source regions are absent, even if the transversal dimension a of the contact window 11 is scaled down to the optical resolution limit of the photolithographic apparatus used for the fabrication of the MOS power device, the contact of the source metal layer (not shown) to both the source regions 60 and the body region 3 of the elementary functional units is guaranteed.

Making reference to Fig. 2, it can be appreciated that the channel perimeter is proportional to the ratio$\text{Lu/(Lu + s)}$ where Lu is the length of one source region 60 in the longitudinal direction and s is the distance between two consecutive source regions 60 (s is the dimension of the transversal portions 40 of the body stripes wherein the source regions are absent, and the transversal portions 40 of the body stripes 3 are functionally inactive areas from the point of view of the current conduction). Since as previously mentioned the on resistance Ron of the MOS power device is inversely proportional to the overall channel perimeter of the power device, it appears that the best result for Ron is achieved by making s as smaLL as possible and Lu as Large as possible; the minimum value for s is given by the optical resolution limit of the photolithographic apparatus, while the maximum value for Lu depends on the particular technology and voltage rating of the MOS power device. In fact, the higher the distance Lu between two consecutive contacts to the body region 3, the higher the base resistance of the parasitic bipolar junction transistor intrinsically associated with the structure formed by the source regions 60, the body stripe 3 and the epitaxial layer 2, and the Lower the maximum current that the MOS power device can withstand during switching; as a consequence, the MOS power device cannot sustain the maximum specified voltage.

In this first embodiment, the source regions 60 in adjacent body stripes 3 are aligned in the transversal direction, i.e. the source regions 60 in adjacent body stripes 3 are one in front of the other. This means that in the portions of the drain Layer 2 comprised between adjacent body stripes 3 there are two current fluxes I (Fig. 3), coming from the facing source regions 60. The distance d between adjacent body stripes 3 cannot therefore be reduced too much.

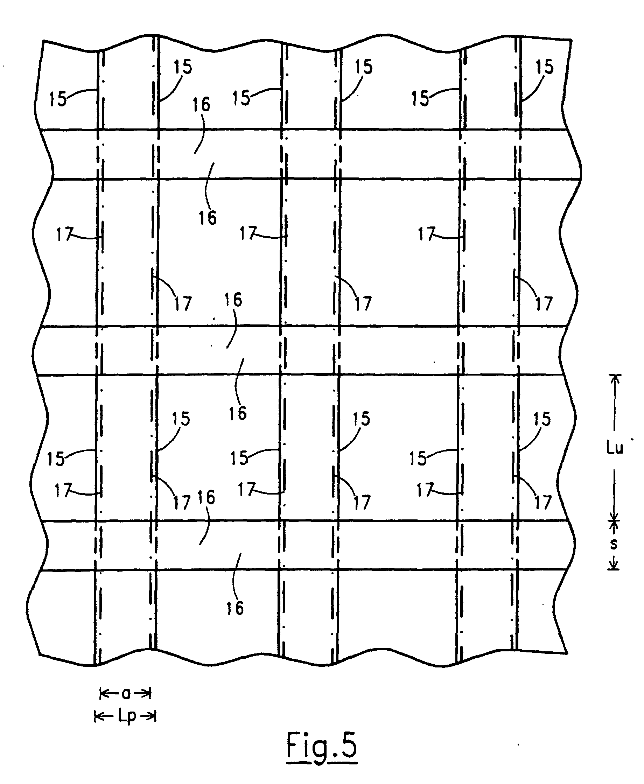

Fig. 5 is a top-plan view showing the Layout and the reciprocal alignment of the photolithographic masks used to fabricate the MOS technology power device structure according to this first embodiment. In the figure, 15 indicates the mask for the selective etching of the poLysiLicon and gate oxide layers, 16 indicates the mask for the selective introduction of the dopants forming the source regions 60, and 17 (in dash-and-dot line) indicates the mask for the opening of the contact windows 11 in the dielectric layer 9.

One suitable process for the fabrication of the MOS technology power device according to the present invention comprises substantially the same steps as the process for the fabrication of the known MOS technology power device structures, and specificaLLy:
- formation of the drain layer 2 over the substrate 1 (generally by means of an epitaxial growth);
- thermal growth of the gate oxide layer 7 over an active area of the drain layer 2, and deposition of the poLysiLicon layer 8;
- selective introduction by means of a mask of a high dose of dopants of the opposite conductivity type of the drain Layer 2 to form heavily doped deep body portions of the body stripes 3;
- selective etching of the poLysiLicon Layer 8, by means of the photolithographic mask 15 to open elongated windows where the elementary functional units of the MOS power device will be formed;
- selective introduction of a low dose of dopants of the opposite conductivity type of the drain layer 2 through said windows to form channel region portions of the body stripes 3;
- formation of the source regions 60 by introducing dopants of the same conductivity type as the drain layer 2 using the photolithographic mask 16;
- deposition of the dielectric Layer 9, and selective etching thereof using the photolithographic mask 17 to open the contact windows 11;
- deposition and patterning of a metal Layer to form the source electrode of the MOS power device.

A preferred manufacturing process allows to eliminate the need of the mask for the formation of the heavily doped deep body portions of the body stripes, using the poLysiLicon Layer as a mask for the formation of both the heavily doped deep body portions and the channel portions of the body stripes. Two alternative of this preferred process wiLL be now described.

A first possibility is to implant a heavy dose of dopants of the opposite conductivity type of the drain layer at an high energy, using as already said the poLysiLicon Layer as a mask (so that the dopants are introduced into the drain Layer through the elongated windows in the poLysiLicon Layer). For example, boron ions can be implanted in a dose of 10¹⁴-10¹⁵ cm⁻² at an energy of 100-300 keV. Due to the high implantation energy, the distribution of the implanted ions has a peak Located at a prescribed distance from the surface of the epitaxial layer, namely under the source regions which will be formed in a Later step of the process; in addition, after the implant the distribution of the implanted ions is laterally aligned with the edges of the windows in the poLysiLicon Layer. The implanted ions are then made to diffuse by means of a thermal process to form the body stripes with a central heavily doped deep body portion, and two lateral Less heavily doped channel portions. The thermal process must have a suitable thermal budget, so that in the channel portions the dopant concentration is suitable to obtain the desired threshold voltage for the MOS power device; a suitable thermal budget is 1050-1100 °C for 0.5 to 2 hours.

A second possibility is to perform two distinct implants, both using the poLysiLicon Layer as a mask. For example, the first implant can involve a dose of dopants in the range 10¹³-10¹⁴ atoms/cm⁻² with an energy of approximately 80 keV and is used to control the dopant concentration at the surface of the body stripes, exspecially in the channel portions, to set the desired threshold voltage of the MOS power device. The second implant involves for example a dose of dopant in the range 10¹⁴-10¹⁵ atoms/cm² with an energy comprised between 100 keV and 300 keV, such that the peak concentration of the dopants can be Located at a prescribed depth, namely under the source regions which will be formed in a Later step. A subsequent thermal diffusion process at a temperature in the range 1050-1100 °C for 0.5 to 2 hours determines the LateraL diffusion of the dopant introduced with the first implant, to form the channel portions of the body stripes extending under the gate oxide Layer; the vertical diffusion of the dopant introduced with the second implant does not alter the threshold voltage of the MOS power device, because the dopant ions reach the surface with a concentration lower than the concentration of the dopant introduced with the first implant (in fact, the peak dopant concentration of the dopant introduced with the first implant is located substantially at the surface of the drain layer 2). The vertical and lateral diffusion of the dopants introduced with the second implant forms the heavily doped deep body portions of the body stripes, reducing the resistivity of the body stripes under the source regions.

From the Layout of Fig. 5 it appears that a misalignment between the mask 15 and the mask 16 in both the LongitudinaL and transversal directions does not have any effect on the final structure, because there will always be source regions 60 intercalated, in the longitudinal direction of the body stripes 3, with transversal portions 40 of the body stripes.

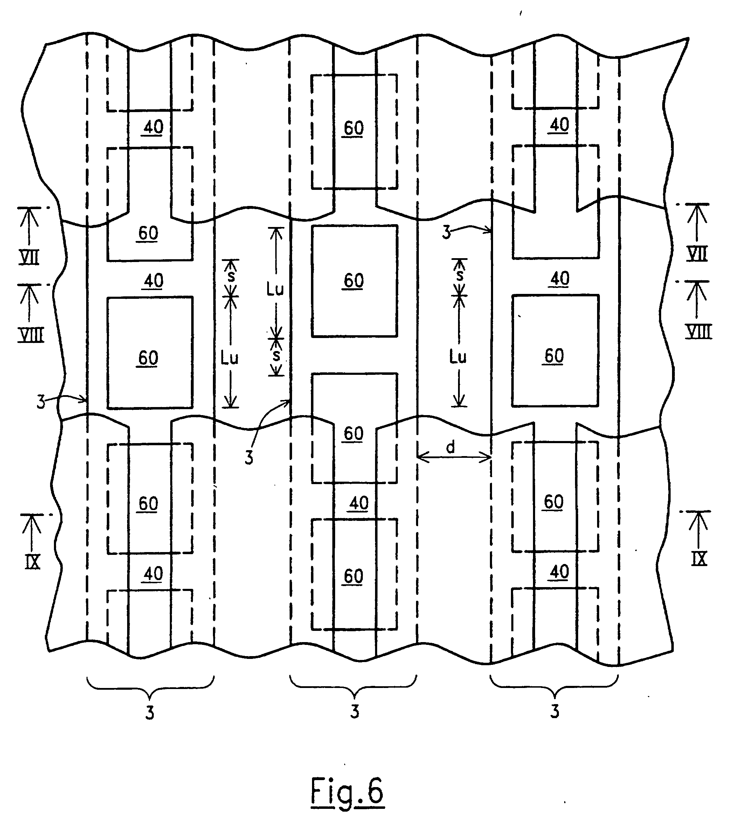

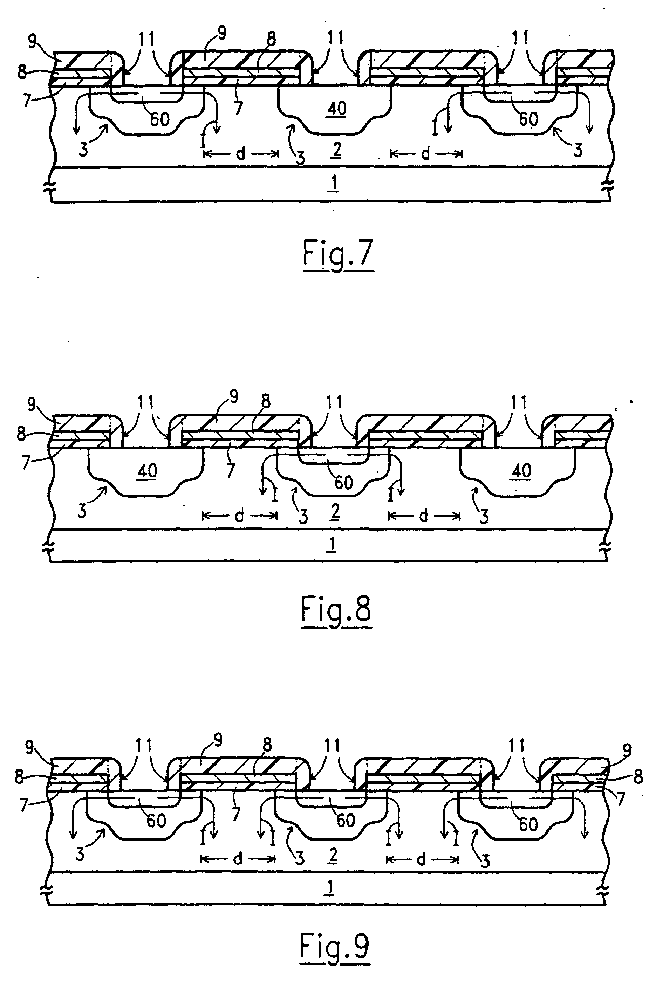

Fig. 6 is a top-plan view of a portion of a MOS power device according to a second embodiment of the present invention. This embodiment is substantially similar to that of Fig. 2, the only difference residing in the fact that the source regions 60 in a given body stripe 3 are shifted in the longitudinal direction with respect to the source regions 60 of the adjacent body stripes 3. In this way, as visible in the cross-sections of Figs. 7, 8 and 9, there are portions of the drain layer 2 between adjacent body stripes 3 wherein there is only one current flux I coming either from the source regions 60 of one body stripe 3 or from the source regions 60 of the adjacent body stripe 3; these portions of the drain layer have a longitudinal dimension equal to s.

Thanks to this arrangement, it i's possible to sLightLy reduce the distance d between the body stripes 3 without increasing the Rjfet component of the Ron; the increased integration density allows an increase of the overall channel perimeter per unit area. However, since to maximize the channel perimeter the dimension s must be small compared with the dimension Lu, the reduction in the distance d is also small, because the portions of the drain layer between the body stripes are mainly interested by the flow of two current fluxes I (Fig. 9).

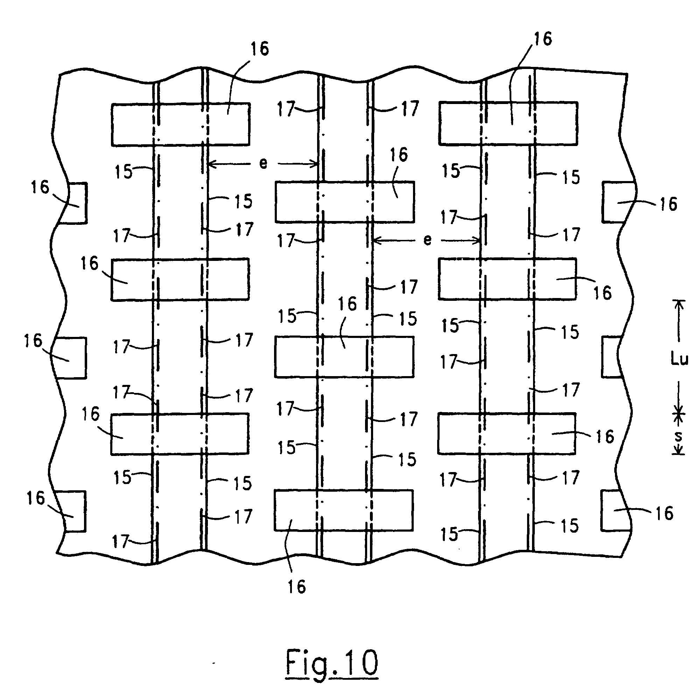

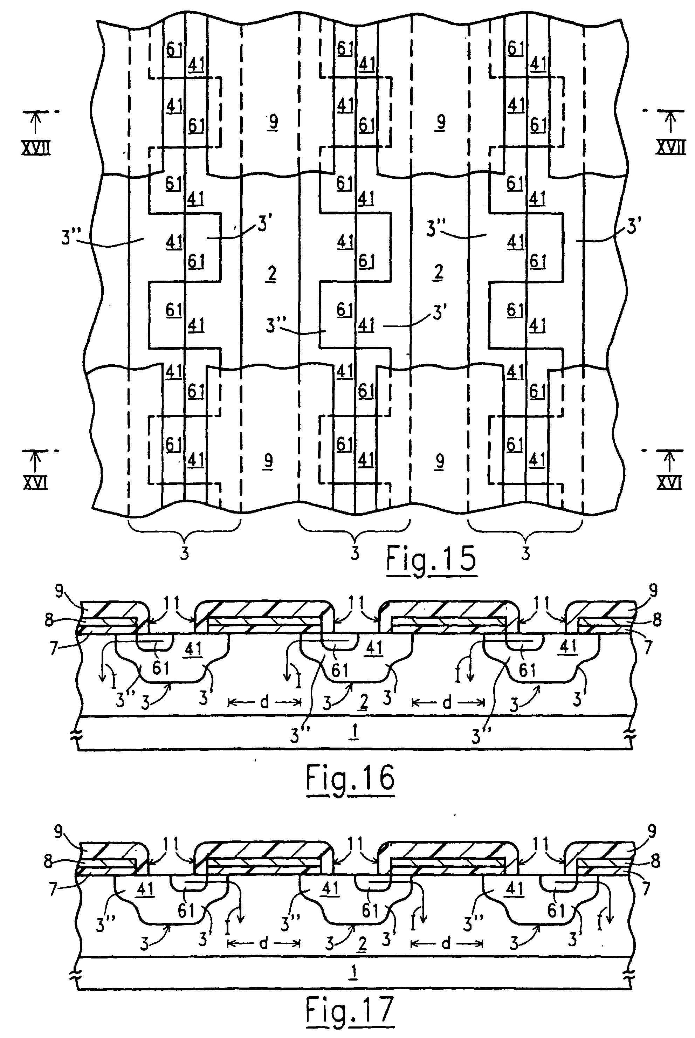

Fig. 10, similarly to Fig. 5, is a top-plan view showing the Layout and the reciprocal alignment of some photolithographic masks used to form the MOS technology power device structure according to this second embodiment. As in Fig. 5, 15 indicates the mask for the selective etching of the polysilicon layer, 16 indicates the mask for the selective introduction of the dopants forming the source regions 60, and 17 indicates (in dash-and-dot line) the mask for the opening of the contact windows 11 in the dielectric Layer 9. To take into account the alignment tolerances of the photolithographic apparatus, the distance e between the windows in the polysilicon Layer must be larger than twice the alignment tolerance Lt of the photolithographic apparatus, to prevent that a misalignment in the transversal direction between the mask 15 and the mask 16 gives rise to an incorrect Layout. However, this is not a major Limitation, because the alignment tolerance of a photolithographic apparatus is normally smaller (approximately 1/4) than its optical resolution Limit, and the dimension e is normally Larger than the optical resolution limit of the photolithographic apparatus.

With these two embodiments it is possible to obtain, with the same manufacturing processes already in use, low-voltage MOS power devices with 1200-4000 cm of channel perimeter per cm² of active area, depending on the photolithographic apparatus in use and on process parameters such as the channel length, equivalent to a cellular MOS power device with a ceLL density ranging from 1.2 to 10 millions of cells per square inch.

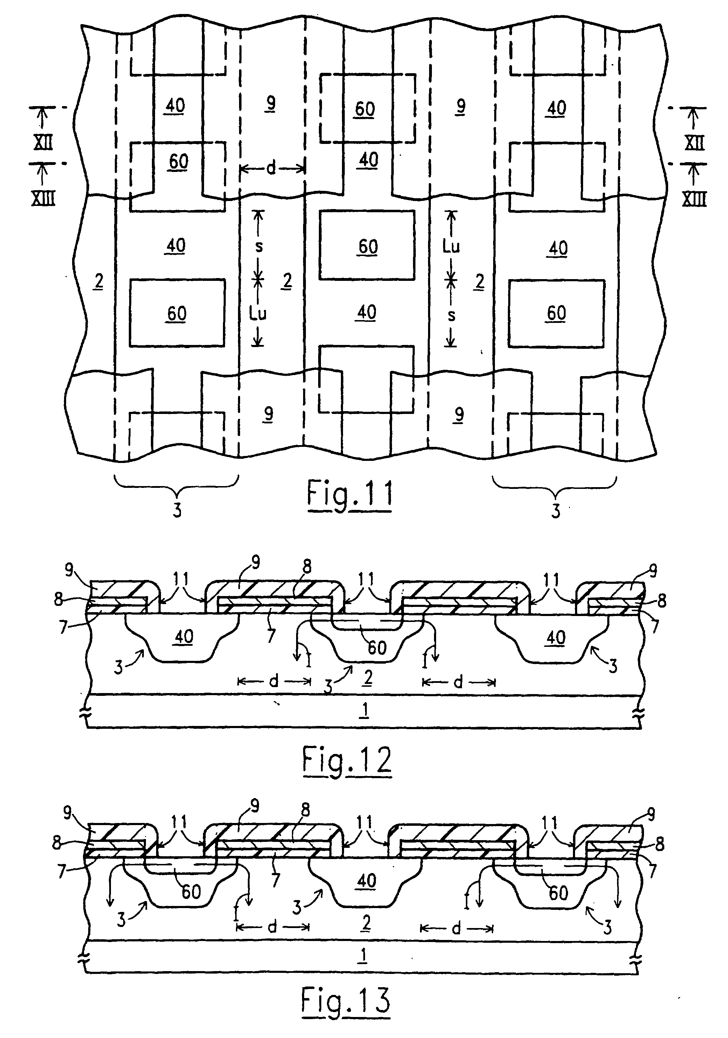

Fig. 11 is a top-plan view of a portion of a non-claimed MOS technology power device, which is substantially a variant of the embodiment of Fig. 6 in that the Length s of the transversal portions 40 of the body stripes 3 wherein the source regions 60 are absent is the same as the length Lu of the source regions 60. The channel perimeter for a single elementary functional unit (body stripe) is approximately a half of that achievable with the structures of the embodiments, but with the distance d between adjacent body stripes reduced to a half, because the source regions 60 of a given body stripe 3 faces the transversal portions 40 of the adjacent body stripes 3; as visible in Figs. 12 and 13, the portions of the drain Layer 2 comprised between the body stripes 3 are always interested by a current flux I coming from only one side.

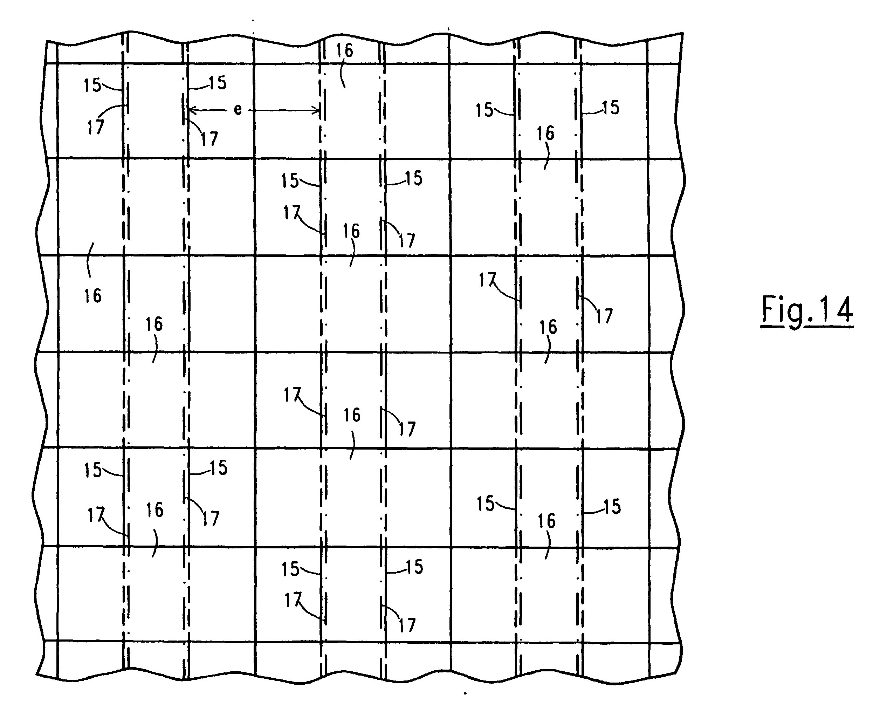

Fig. 14 is analogous to Figs. 5 and 10, and is a top-plan view showing the Layout and the reciprocal alignment of some photolithographic masks used to fabricate the structure of Fig. 11. Again, the mask for the selective etching of the poLysiLicon layer is indicated with 15, the mask for the selective introduction of the dopants for the source regions 60 is indicated with 16, and the mask for the opening of the contact windows 11 (in dash-and-dot) is indicated with 17. As in the case of Fig. 10, the distance e between adjacent windows in the poLysiLicon layer must be greater than twice the alignment tolerance Lt of the photolithographic apparatus in use, to take into account the possible alignment errors between the mask 15 and the mask 16. However this is not a major Limitation, because as already mentioned Lt is approximately 1/4 of the optical resolution limit, and even if this embodiment allows a significant reduction of the distance d between adjacent body stripes, the dimension e (equal to or higher 4 µm) must be higher than the optical resolution limit of the photolithographic apparatus.

Fig. 15 is a top-plan view of a portion of a non-claimed MOS power device whereih each body stripe 3 is ideally divided into two longitudinal half-stripes 3' and 3", and in each half-stripe source regions 61 of the opposite conductivity type of the body stripe 3 are intercalated in the longitudinal direction with body portions 41 of the half-stripe wherein the source regions are absent. In addition, the source regions 61 in one half-stripe are contiguous to the body portions 41 of the other half-stripe, and face the body portions 41 of the adjacent body stripe 3.

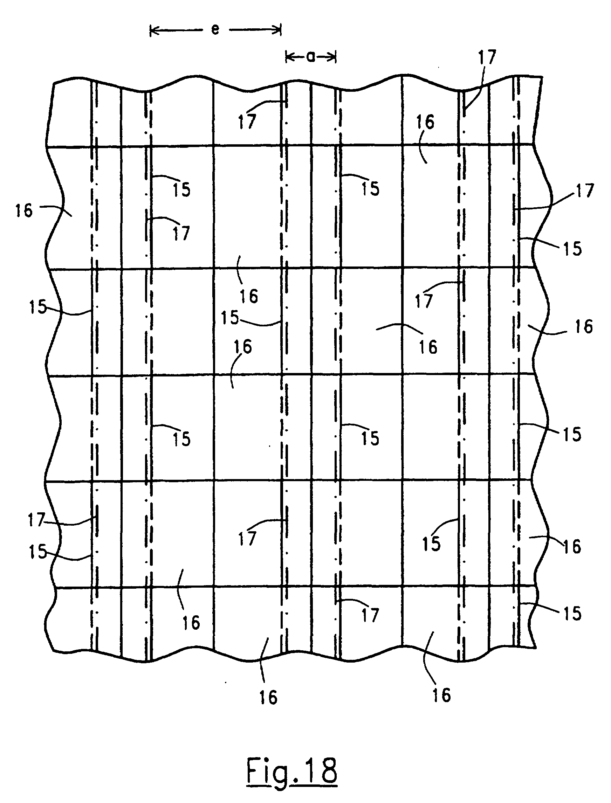

Fig. 18 is analogous to Figs. 5, 10 and 14, and is a top-plan view showing the Layout and the reciprocal alignment of some photolithographic masks used to fabricate the structure of Fig. 15. Again, 15 indicates the mask for the selective etching of the poLysiLicon layer, 16 indicates the mask for the formation of the source regions 61, and 17 indicates the mask (in dash-and-dot Line) for the opening of the contact windows 11 in the dielectric layer. It can be appreciated that the Layout of the three masks is substantially the same as that of Fig. 14, the only difference being the different alignment of mask 16 with respect to mask 15. In this case not only it is necessary that the distance e between adjacent windows in the poLysiLicon layer is greater than twice the alignment tolerance Lt of the photolithographic apparatus in use, but also the dimension a of the contact window must be greater than 2Lt, to prevent that alignment errors between mask 15 and mask 16 determine an incorrect Layout. However, since the minimum value for dimension a is the optical resolution Limit of the photolithographic apparatus, and since the alignment tolerance Lt is approximately 1/4 the optical resolution limit, the necessity to take into account the possible alignment errors between masks 15 and 16 does not prevent to shrink the transversal dimension of the elementary functional units: the contact of the source metal layer (not shown) to the source regions 61 and to the body portions 41 is guaranteed even if the dimension a of the contact window 11 is reduced to the optical resolution limit of the photolithographic apparatus.

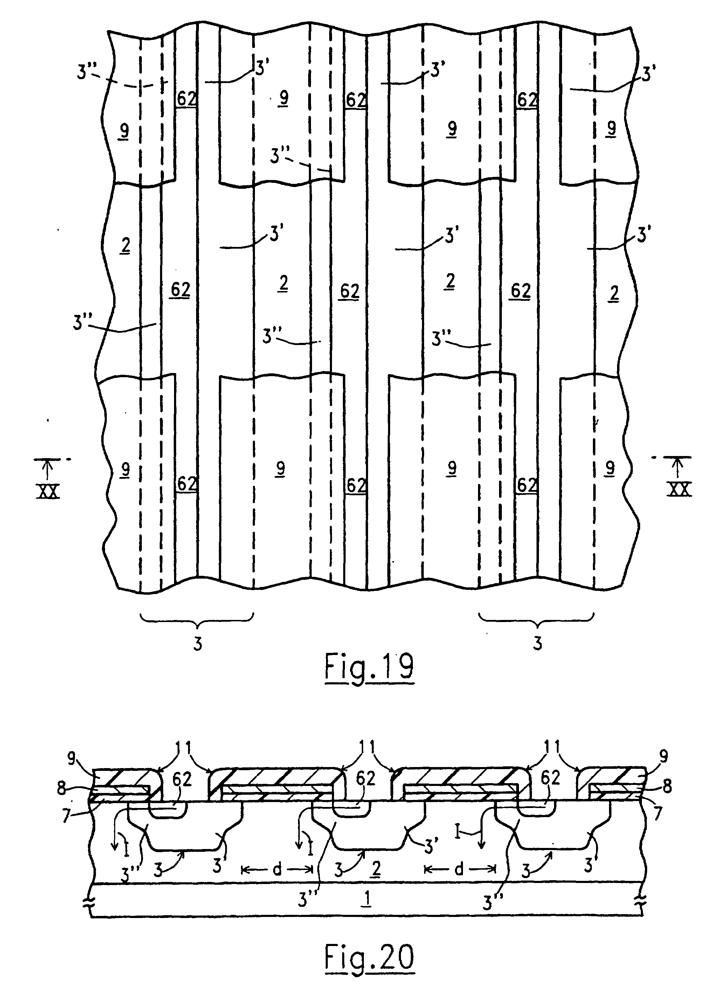

Fig. 19 is a top-plan view of a non-claimed MOS power device wherein each body stripe 3 is divided in two half-stripes 3' and 3"; in one (3") of the two half-stripes 3', 3", a source region 62 is provided that extends substantiaLLy for the whole length of the body stripe 3, while in the other half-stripe (3'), no source region is provided at all. As with the arrangement of Fig. 15, it is possible to reduce the distance d between adjacent body stripes, because in the portions of the drain layer 2 comprised between adjacent body stripes there is a current flux I coming from only one side (Fig. 20).

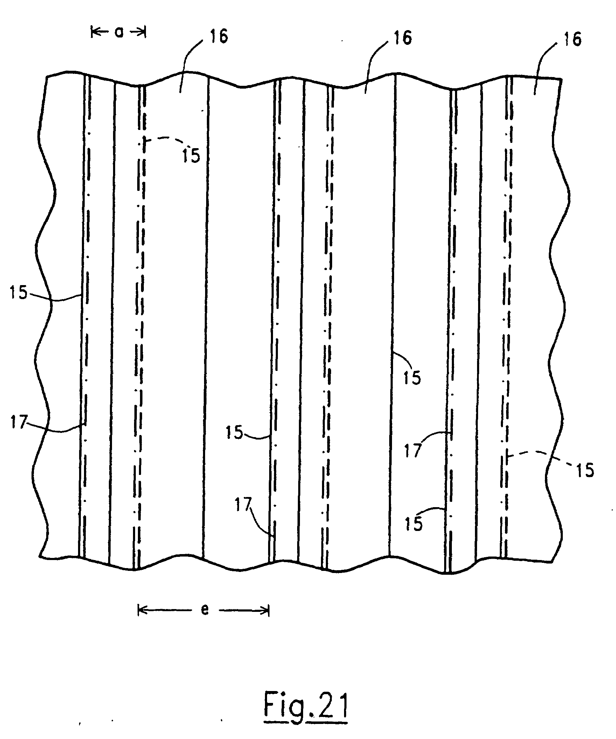

Fig. 21 is a top-plan view showing the Layout and the reciprocal alignment of the photolithographic masks used to form the structure of Fig. 19. The same numerals as in Figs. 5, 10, 14 and 18 have been used. As in the case of the fourth embodiment, both the distance e between adjacent openings in the poLysiLicon layer and the dimension a of the contact window 11 in the dielectric layer 9 must be at Least twice the alignment tolerance Lt of the photolithographic apparatus in use, to prevent Layout erros due to the alignment errors between the mask 15 and the mask 16.

## Claims

1. MOS technology power device comprising a plurality of transistor which contribute for respective fractions to an overall current of the power device and which are formed in a semiconductor material layer (2) of a first conductivity type, each transistor comprising a body region (3) of a second conductivity type formed in the semiconductor material layer (2), the body region (3) having the form of a plurality of substantially parallel body stripes (3) elongated in a longitudinal direction on a surface of the semiconductor material layer (2), each body stripe (3) continuously extending along said longitudinal direction substantially for the whole length of the stripe and including at least one plurality of source portions (60) doped with dopants of the first conductivity type, said at least one plurality of source portions (60) being aligned along said longitudinal direction of the body stripe and being intercalated in the longitudinal direction with at least one plurality of body portions (40) of the body stripe (3) wherein no dopants of the first conductivity type are provided, said plurality of source portions (60) and said plurality of body portions (40) extending in a direction transversal to the body stripes (3), the source portions being centered in the body stripes in said direction transversal to the body stripes the device further comprising a plurality of dielectric stripes (9) which are substantially parallel to the plurality of elongated body stripes (3) and alternated thereto, said plurality of dielectric stripes (9) continuously extending along said longitudinal direction substantially for the whole length of the stripe and being arranged so as to form elongated contact windows (11) over the central portion of each elongated body stripe (3), said elongated contact windows (11) providing contact regions for both the source portions (60) and the transversal body portions (40) of the body stripes (3), said contact regions being isolated from each other, **characterized in that** the dimension (Lu) of said source portions (60) along the longitudinal direction is larger than the dimension (s) of said body portions (40) along the longitudinal direction to maximize the channel perimeter.

2. MOS technoLogy power device according to claim 1, **characterized in that** the source portions (60) and the body portions (40) of a body stripe (3) are substantially aligned in the transversal direction with respect to their central portion respectively with the source portions (60) and the body portions (40) of adjacent body stripes (3).

3. MOS technology power device according to claim 2, **characterized in that** the source portions (60) and the body portions (40) of a body stripe (3) are substantially aligned in the transversal direction with respect to their central part respectively with the body portions (40) and the source portions (60) of adjacent body stripes (3).

4. MOS technology power device according to anyone of the preceding claims, **characterized in that** said semiconductor material Layer (2) is superimposed over a semiconductor material substrate (1).

5. MOS technology power device according to claim 4, **characterized in that** said semiconductor material layer (2) is lightly doped, and said semiconductor material substrate (1) is heavily doped.

6. MOS technology power device according to claim 5, **characterized in that** said semiconductor material substrate (1) is of the first conductivity type.

7. MOS technology power device according to claim 5, **characterized in that** said semiconductor material substrate (1) is of the second conductivity type.

8. MOS technology power device according to anyone of the preceding claims, **characterized in that** said first conductivity type is the N conductivity type, and said second conductivity type is the P conductivity type.

9. MOS technology power device according to anyone of claims 1-7, **characterized in that** said first conductivity type is the P conductivity type, and the second conductivity type is the N conductivity type.

## Patentansprüche

1. MOS-Technologie-Leistun-gavorrichtung mit einer Mehrzahl von Transistoren, die jeweilige Bruchteile zu einem Gesamtstrom der Leistungsvorrichtung beitragen und die in einer Ilalbleitermaterialechicht (2) eines ersten Leitfähigkeitstyps ausgebildet sind, wobei:
jeder Transistor einen in der Halbleitermaterialschicht (2) ausgebildeten Körperbereich (3) eines zweiten Leitfähigkeitstyps aufweist,
der Körperbereich (3) die Form einer Mehrzahl von im Wesentlichen parallelen in einer longitudinalen Richtung auf einer Oberfläche der Halbleitermaterialschicht (2) ausgestreckten Körperstreifen (3) aufweist,
sich jeder Körperstreifen (3) im Wesentlichen über die gesamte Länge des Streifens kontinuierlich entlang der longitudinalen Richtung erstreckt und wenigstens eine Mehrzahl von mit Dotiermaterial des ersten Leitfähigkeitstyps dotierten Quellabschnitten (60) aufweist,
die wenigstens eine Mehrzahl von Quellabschnitten (60) entlang der longitudinalen Richtung des Körperstreifens in der longitudinalen Richtung mit wenigstens einer Mehrzahl von Körperabschnizten (40) des Körperstreifens (3), die nicht mit Dotiermaterial des ersten Leitfähigkeitstyps versehen sind, dazwischenliegend ausgerichtet sind,
sich die Mehrzahl von Quellbereichem (60) und die Mehrzahl von Körperabschnitten (40) in einer zu den Körperstreifen (3) transversalen Richtung erstrecken,
die Quellabschnitte in den Körperstreifen im der Richtung transversal zu den Körperstreifen zentriert sind,
die Vorrichtung weiter eine Mehrzahl von dielektrischen Streifen (9) aufweist, die im Wesentlichen parallel zu der Mehrzahl von länglichen Körperstreifen (3) und dazu abwechselnd angeordnet sind,
die Mehrzahl von dielektrischen Streifen (9), die sich im wesentlichen über die gesamte Länge des Streifens kontinuierlich entlang der longitudinalen Richtung erstrecken, so angeordnet sind, dass sie über den zentralabschnitt jedes länglichen Körperstreifens (3) ausgestreckte Kontaktfenster (11) bilden,
die ausgestreckten Kontaktfenster (11) Kontaktbereiche für sowohl die Quellabschnitte (60) als auch die transversalen Körperabschnitte (40) der Körperstreifen (3) bereitstellen, und
die kontaktbereiche voneinander isoliert sind,
**dadurch gekennzeichnet, dass** die Abmessung (Lu) der Quellabschnitte (60) entlang der longitudinalen Richtung größer ist, als die Abmessung (s) der Körperabschnitte (40) entlang der longitudinalen Richtung, um den Kanalumfang zu maximieren.

2. MOS-Technologie-Leistungsvorrichtung nach Anspruch 1, **dadurch gekennzeichnet, dass** die Quellabschnitte (60) und die Körperabschnitte (10) cinco Körpcrstreifene (3) im Wesentlichen in der bezüglich ihres Zentralabachnitts transversalen Richtung mit den Quellabschnitten (60) bzw. den Körperabschnitten (40) benachbarter Körperstreifen (3) ausgerichtet sind.

3. MOS-Technologie-Leistungsvorrichtung nach Anspruch 2, da, durch gekennzeichnet, dass die Quellabschnitte (60) und die Körperabschnitte (40) eines Körperstreifens (3) im Wesentlichen in der bezüglich ihres Zentralteils transversalen Richtung mit den Körperabschnitten (40) bzw. den Quellabschnitten (60) benachbarter Körperstreifen (3) ausgerichtet sind.

4. MOS Tcchnelogie-Leistungsvorrichtung nach einem der vorhergehenden Ansprüche, **dadurch gekennzeichnet, dass** die Halbleitermaterialschicht (2) über ein Halbleitermaterialcubctrat (1) überlagert ist.

5. MOS-Technologie-Leistungsvorrichtung nach Anspruch 4, **dadurch gekennzeichnet, dass** die Halbleitermaterialschicht (2) leicht dotiert und das Halbleitermaterialsubstrat (1) stark dotiert ist.

6. MOS-Technologie-Leistunqsvorrichtung nach Anspruch 5, **dadurch gekennzeichnet, dass** das Halbleitermaterialsubstrat (1) vom ersten Leitfähigkeitstyp ist.

7. MOS-Technologie-Leistungsvorrichtung nach Anspruch 5, **dadurch gekennzeichnet, dass** das Halbleitermaterialsubstrat (1) vom zweiten Leitfähigkeistyp ist.

8. MOS-Technologie-Leistungsvorrichtung nach einem der vorhergehenden Ancprüche, **dadurch gekennzeichnet, dass** der erste Leitfähigkeitstyp der N-Leitfähigkeitstyp und der zweite Leitfähigkeitstyp der P-Leitfähigkeitstyp ist.

9. MOS-Technologie-Leistungsvorrichtung nach einem der Ansprüche 1-15, **dadurch gekennzeichnet, dass** der erste Leitfähigkeitstyp der P-Leitfähigkeitstyp und zweite Leitfähigkeitetyp der N-Leitfähigkeitstyp ist.

## Revendications

1. Dispositif de puissance formé en technique MOS, comprenant une pluralité de transistors qui contribuent, pour des fractions respectives, au courant global du dispositif de puissance et qui sont formés dans une couche (2) de matériau semiconducteur d'un premier type de conductivité, chaque transistor comprenant une région corps (3) du deuxième type de conductivité, formée dans la couche (2) de matériau semiconducteur, la région corps (3) ayant la forme d'une pluralité de bandes de corps sensiblement parallèles (3) qui sont allongées suivant la direction longitudinale sur une surface de la couche de matériau semiconducteur, chaque corps s'étendant de manière continue suivant ladite direction longitudinale pour sensiblement toute la longueur de la bande et comportant au moins une pluralité de parties source (60) dopées au moyen d'agents dopants du premier type de conductivité, ladite ou lesdites parties source (60) étant alignées suivant ladite direction longitudinale de la bande de corps et intercalées dans la direction longitudinale avec au moins une pluralité de parties corps (40) de la bande de corps (3), où aucun agent dopant du premier type de conductivité n'est fourni, ladite pluralité de parties source (60) et ladite pluralité de parties corps (40) s'étendant suivant une direction qui est transversale par rapport aux bandes de corps (3), les parties source étant centrées dans les bandes de corps dans ladite direction transversale par rapport aux bandes de corps, le dispositif comprenant en outre une pluralité de bandes diélectriques (9) qui sont sensiblement parallèles à la pluralité de bandes de corps allongées (3) et disposées en alternance avec celles-ci, ladite pluralité de bandes diélectriques (9) s'étendant de manière continue le long de ladite direction longitudinale pour sensiblement toute la longueur de la bande et étant disposées de façon à former des fenêtres de contact allongées (11) sur la partie centrale de chaque bande de corps allongée (3), lesdites fenêtres de contact allongées (11) produisant des régions de contact à la fois pour les parties source (60) et les parties corps transversales (40) des bandes de corps (3), lesdites régions de contact étant isolées les unes des autres, le dispositif étant **caractérisé en ce que** la dimension (Lu) desdites parties source (60) suivant la direction longitudinale est plus grande que la ou les corps (40) suivant la direction longitudinale de façon à maximiser le périmètre de canal.

2. Dispositif de puissance MOS selon la revendication 1, **caractérisé en ce que** les parties source (60) et les parties corps (40) d'une bande de corps (3) sont sensiblement alignées, dans la direction transversale, par rapport à leur partie centrale, respectivement avec les parties source (60) et les parties corps (40) de bandes de corps adjacentes (3).

3. Dispositif de puissance MOS selon la revendication 2, **caractérisé en ce que** les parties source (60) et les parties corps (40) d'une bande de corps (3) sont sensiblement alignées, dans la direction transversale par rapport à leur partie centrale, respectivement avec les parties corps (40) et les parties source (60) de bandes de corps adjacentes (60).

4. Dispositif de puissance MOS selon l'une quelconque des revendications précédentes, **caractérisé en ce que** ladite couche (2) de matériau semiconducteur est superposée à un substrat (1) de matériau semiconducteur.

5. Dispositif de puissance MOS selon la revendication 4, **caractérisé en ce que** ladite couche (2) de matériau semiconducteur est légèrement dopée, et ledit substrat (1) de matériau semiconducteur est fortement dopé.

6. Dispositif de puissance MOS selon la revendication 5, **caractérisé en ce que** ledit substrat (1) de matériau semiconducteur est du premier type de conductivité.

7. Dispositif de puissance MOS selon la revendication 5, **caractérisé en ce que** ledit substrat (1) de matériau semiconducteur est du deuxième type de conductivité.

8. Dispositif de puissance MOS selon l'une quelconque des revendications précédentes, **caractérisé en ce que** ledit premier type de conductivité est le type de conductivité N et ledit deuxième type de conductivité est le type de conductivité P.

9. Dispositif de puissance MOS selon l'une quelconque des revendications 1 à 7, **caractérisé en ce que** ledit premier type de conductivité est le type de conductivité P et le deuxième type de conductivité est le type de conductivité N.
